# EUROPÄISCHE PATENTSCHRIFT

(11) **EP 0 580 886 B1**
(45) Veröffentlichungstag und Bekanntmachung des Hinweises auf die Patenterteilung: **21.06.1995**
(21) Anmeldenummer: 92112960.7
(22) Anmeldetag: 29.07.1992
(51) Int. Cl.: H01M 2/10

(54) **Handsender eines fernsteuerbaren Schliesssystemes, bevorzugt für ein Kfz**
Portable transmitter providing remote control of a locking means, in particular adapted to an automobile
Emetteur portable destiné à la commande à distance d'un système de verrouillage, en particulier pour voitures automobiles

(43) Veröffentlichungstag der Anmeldung: 02.02.1994
(73) Patentinhaber: SIEMENS AKTIENGESELLSCHAFT, 80333 München (DE)
(72) Erfinder: Kraiczyk, Josef, W-8400 Regensburg (DE); Thelen, Helmut, Dipl.-Ing., W-8400 Regensburg (DE)

(56) Entgegenhaltungen:
- EP-A- 0 117 204
- DE-A- 4 037 555
- DE-A- 4 220 214
- IBM TECHNICAL DISCLOSURE BULLETIN. Bd. 30, Nr. 8, Januar 1988, NEW YORK US, Seiten 424-425 'Method of mounting multiple circuit cards in a case'

## Beschreibung

Die Erfindung wurde zwar zunächst für das ferngesteuerte Schließsystem eines Kfz entwickelt. Es zeigte sich aber, daß ihr Konzept auch auf sonstige fernsteuerbare Schließsysteme anwendbar ist, welche einen Handsender aufweisen.

Die Erfindung geht von dem im Oberbegriff des Patentanspruches 1 definierten Gegenstand aus, der für sich dem Fachmann für Kfz-Elektronik vielfach vorbekannt ist. Ein Vorbild für die Erfindung war besonders der in der
- EP-Anmeldung 92.111816.2 (= GR 92 P 1400 E)
beschriebene konstruktive Aufbau eines solchen Handsenders.

Ein Hauptproblem solcher Handsender ist ihre Handlichkeit. Sie sollen möglichst klein, damit die Elektronik im Inneren des Handsenders möglichst kompakt sein, auch gewichtsmäßig leicht, für einen Batteriewechsel leicht zu öffnen und wieder zu verschließen sein sowie - um leicht die Bedientasten auffinden, erfühlen und greifen zu können - mehr oder weniger griffig-flach, und trotzdem leicht herzustellen sein.

Diese komplexe Aufgabe wird durch die Erfindung auf einem neuen Weg durch den im Patentanspruch 1 definierten Gegenstand gelöst.

Die in den Unteransprüchen definierten Gegenstände gestatten, zusätzliche Vorteile zu erreichen. U.a. gestatten nämlich die zusätzlichen Maßnahmen gemäß dem Patentanspruch
- 2,: beim Batteriewechsel eine Verschmutzung oder Beschädigung der Bauteile zu vermeiden, selbst wenn dabei sehr unachtsam mit dem Handsender umgegangen wird,
- 3,: während eines Batteriewechsels nicht nur - durch einen ausreichend groß dimensionierbaren Abstand der Batterie von den Bauteilen - eine Beschädigung der betreffenden Bauteile leicht vermeiden zu können, sondern auch auf einfache Weise das Herausfallen der Batterie vermeiden zu können, indem die Batterie beim Batteriewechsel zunächst in der Abdeckung befestigt werden kann, bevor die Abdeckung mit dem den Tragekörper vereinigt wird,
- 4,: nicht nur durch einen ausreichenden Abstand der Batterie von den Bauteilen - besonders während eines Batteriewechsels - eine Beschädigung der betreffenden Bauteile vermeiden zu können, sondern auch einen Batteriewechel relativ leicht handhabbar zu machen,
- 5 und 6,: auf besonders einfache, kompakte Weise die Kontaktierung der Batterie erreichen zu können,
- 6 und 7,: zusätzlich während des Batteriewechsels einen gewissen Schutz der unter der Fahne angebrachten Bauteile gegen Verschmutzung und Beschädigung erreichen zu können,
- 8,: eine besonders flache, kompakte Bauweise zu ermöglichen,
- 9,: während des Batteriewechsels einen besonders großen Schutz der unter der Fahne angebrachten Bauteile gegen Verschmutzung und Beschädigung erreichen zu können,
- 10,: eine besonders kompakte Konstruktion des Handsender erreichen zu können, wobei die Bauteile, welche auf der von der Batterie abgewandten Seite der Leiterplatte angebracht sind, beim Batteriewechsel besonders gut gegen Verschmutzung und Beschädigung geschützt sind, und
- 11,: auf besonders einfache, kompakte, leicht herstellbare Weise eine entsprechend große Versorgungsspannung und Energiereserve für die Bauteile zu Verfügung stellen zu können.

Die Erfindung und Weiterbildungen derselben werden anhand der in den sechs Figuren gezeigten schemenhaften Querschnitten durch Ausführungsbeispiele der Erfindung weiter erläutert, welche der Übersichtlichkeit wegen jeweils möglichst einfach dargestellt wurden.

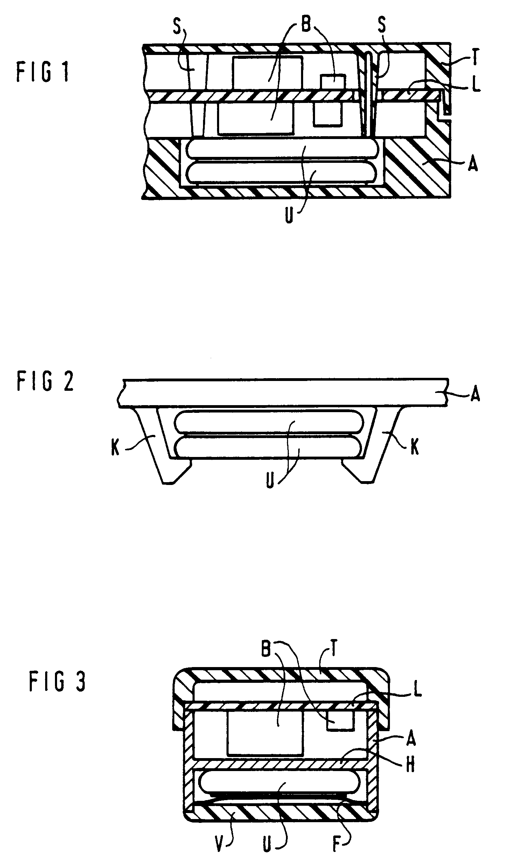

Weil die erfindungsgemäße Lösung weitgehend den konstruktiven Aufbau im Inneren des Gehäuses betrifft, ist nur in den Figur 1 und 3 je ein Beispiel für die äußere Form des Gehäuses angedeutet - diese äußere Form kann an sich nahezu beliebig sein und richtet sich nach sonstigen Bedürfnissen, z.B. nach der Anordnung von Bedienelementen wie Tasten.

Das Gehäuse bildet eine Gehäuseschale, in deren Inneren jeweils die Bauteile der Elektronik liegen. Diese Gehäuseschale besteht bei der Erfindung aus zumindest zwei Teilen, weil der Benutzer das Gehäuse zum Batteriewechseln auch öffnen können soll, und oft auch weil z.B. zu Reparaturzwecken die Leiterplatte L aus dem Gehäuse herausnehmbar sein soll, vgl. die Figur 1. Dort besteht die Gehäuseschale beispielhaft aus dem Tragekörper T und der Abdeckung A. Die Gehäuseschale kann aber noch zusätzliche Teile enthalten, vgl. die Figur 3. Dort besteht die Gehäuseschale aus dem Tragekörper T, der Abdeckung A und einem Deckel V. In den übrigen Figuren wird jeweils nur die räumliche Anordnung der Bauteile im Inneren des Gehäuses gezeigt.

Der Handsender enthält zusätzlich elektronische Bauteile B, die auf einer Leiterplatte L im Gehäuse angebracht sind. Die Leiterplatte L wird vom Tragekörper T getragen, indem die Leiterplatte L daran z.B. durch Schrauben, Klemmen u. dgl. befestigt sind oder indem die Leiterplatte L zumindest durch entsprechende Formgebungen des Tragekörpers T - z.B. durch Stütznasen, Anpreßkanten o.dgl. - in einer bestimmten Lage im fertig montierten Gehäuse stabilisiert wird.

Im Gehäuse ist zusätzlich eine Batterie U zur Stromversorgung der Bauteile B über Leiterbahnen der Leiterplatte L angebracht. Die Batterie U wird erfindungsgemäß durch mindestens eine - zumindest angenähert einen Rotationskörper darstellende - Knopfzelle U gebildet, die so räumlich orientiert im Gehäuse angebracht ist, daß ihre Achse mehr oder weniger senkrecht zur Ebene der Leiterplatte L steht, vgl. die Figuren 1 bis 6. Auf diese Weise kann die Außenoberfläche des Gehäuses unmittelbar oberhalb der Knopfzelle U mehr oder weniger flach gemacht werden, so daß der Benutzer des Handsenders auch in der Dunkelheit leicht fühlen kann, wie er den Handsender beim ferngesteuerten Öffnen oder Schließen des Schlosses halten muß.

Bei der Erfindung liegt bzw. "schwebt" die Knopfzelle U oberhalb der Leiterplatte L, statt neben der Leiterplatte L oder auch statt unmittelbar auf der Leiterplatte L angebracht zu sein. Bei der Erfindung ist nämlich die Knopfzelle U in der Weise oberhalb der Leiterplatte L angebracht, vgl. die sechs Figuren, daß die senkrechte Projektion der Knopfzelle U auf der Leiterplatte L - also der "Schatten" der Knopfzelle bei einer Beleuchtung senkrecht zur Ebene der Leiterplatte L - jeweils zumindest eines der Bauteile B zumindest teilweise bedeckt. Dadurch kann bei der Erfindung die Leiterplatte L besonders klein und der Handsender besonders kompakt gemacht werden, wodurch die ganze Fläche der Leiterplatte L für die elektronischen Bauteile B des Handsenders zur Verfügung steht, so daß auch im Raum zwischen der Knopfzelle U und der Leiterplatte L noch Bauteile auf der Leiterplatte L angebracht werden können.

Die besondere räumliche Gestaltung im Inneren des Handsenders gestattet also, daß der Handsender klein und kompakt, auch gewichtsmäßig leicht ist sowie für einen Batteriewechsel leicht zu öffnen und wieder zu verschließen und - um leicht die Bedienelemente (z.B. Tasten) auffinden, erfühlen und greifen zu können - mehr oder weniger griffig-flach, und trotzdem leicht herstellbar ist.

Um beim Batteriewechsel eine Verschmutzung oder Beschädigung der Bauteile B zu vermeiden, selbst wenn dabei sehr unachtsam mit dem Handsender umgegangen wird, kann die Knopfzelle U von dem/den bedeckten Bauteil/-en B durch eine massive Trennschicht H getrennt sein, vgl. die Figur 3.

Um während eines Batteriewechsels nicht nur - durch einen ausreichend groß dimensionierbaren Abstand der Knopfzelle U von den Bauteilen B - eine Beschädigung der betreffenden Bauteile B auf einfache Weise vermeiden zu können, sondern auch auf einfache Weise ein zu leichtes Herausfallen der Batterie U vermeiden zu können, wird die Knopfzelle U beim Batteriewechsel zunächst in der Abdeckung A mittels elastischer bzw. federnder Klammern befestigt, bevor die Abdeckung A mit dem den Tragekörper T vereinigt wird, vgl. das in der Figur 2 gezeigte Beispiel für solche Klammern K. Dann wird durch diese Klammern K indirekt auch der Abstand der Knopfzelle U zu dem/den Bauteil/-en B erzeugt.

Um durch einen ausreichenden Abstand der Knopfzelle U von den Bauteilen B - während eines Batteriewechsels aber auch während der Montage des Handsenders in den Werkstätten des Herstellers - eine Beschädigung der betreffenden Bauteile B vermeiden zu können, falls diese besonders empfindlich sind, und auch um einen Batteriewechel relativ leicht handhabbar zu machen, kann die Knopfzelle U im Gehäuse durch am Tragekörper T und / oder auf der Leiterplatte L angebrachte Stützen S fixiert werden, vgl. die Figuren 1 und 6. Mittels dieser Stützen S kann nämlich ein ausreichender Abstand der Knopfzelle U zu dem/den Bauteil/-en B erzeugt werden.

Die Kontaktierung der Knopfzelle U kann man im erfindungsgemäßen Gehäuse auf unterschiedliche Weise erreichen. Einige Varianten davon erwiesen sich als besonders günstig.

Auf besonders einfache, kompakte Weise kann die Kontaktierung erreichen, indem zumindest eine der bereits erwähnten Stützen S einen Kontaktfinger S enthält oder darstellt, welcher ein Potential der Knopfzelle U zu einer Leiterbahn der Leiterplatte L weiterleitet, vgl. die Figur 6 mit der Figur 1.

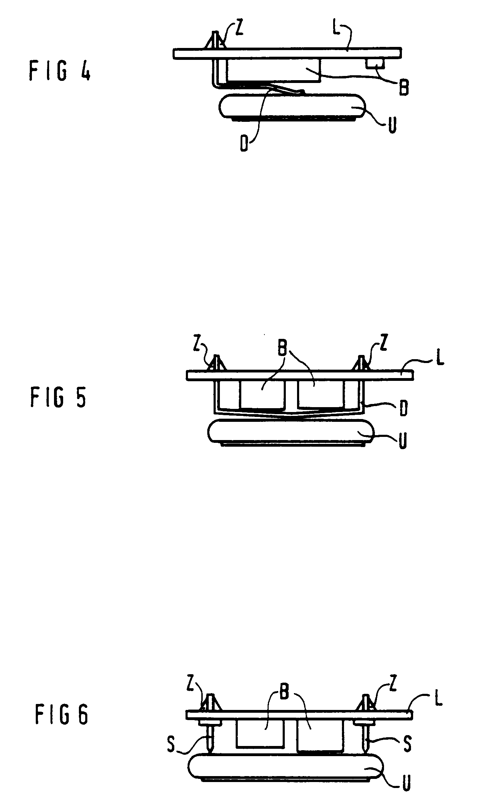

Auf ähnlich einfache, kompakte Weise kann man aber auch die Leiterplatte L mit einer leitenden Fahne D ausstatten, welche ein Potential der Knopfzelle U zu einer Leiterbahn der Leiterplatte L weiterleitet. Vgl. die Beispiele in den Figur 4 und 5.

Bei dem in der Figur 4 gezeigten Beispiel bedeckt die Fahne D, die hier nur an ihrem einen Ende über die Lötstelle Z mit einer Leiterbahn der Leiterplatte L verbunden ist, nur relativ kleine Teile von Bauteilen B.

Bei dem in der Figur 5 gezeigten Beispiel bedeckt die Fahne D, die hier brückenartig an ihren beiden Enden über Lötstellen Z mit einer oder mehreren Leiterbahnen der Leiterplatte L verbunden ist, entsprechend größere Teile von Bauteilen B, wobei die Mitte dieser Brücke D so gegen die Knopfzelle U gekrümmt ist oder so zur Knopfzelle U hin vorspringt, daß dort über die Brücke D ein Potential der Knopfzelle U zu einer Leiterbahn der Leiterplatte L weitergeleitet wird.

Die Erfindung gestattet dann aber auch eine besonders kompakte, flache Bauweise, wenn nämlich, sobald die Knopfzelle U im Gehäuse angebracht ist, die Knopfzelle U die Fahne D in der Weise stark zusammendrückt, daß die Knopfzelle U auf die Fahne D, und die Fahne D auf mindestens eines der unter der Fahne D angebrachten Bauteile B drückt, vgl. damit die Figuren 4 und 5. Dann ist nämlich der Spalt zwischen der Knopfzelle U und diesem Bauteil sehr eng - er enthält im wesentlichen nur die für sich in der Regel sehr flache Fahne D.

Um während des Batteriewechsels einen besonders großen Schutz der unter der Fahne D angebrachten Bauteile gegen Verschmutzung und Beschädigung erreichen zu können sowie um eine besonders kompakte Konstruktion zu erhalten, kann die Leiterplatte L sehr klein gemacht werden und die - für sich schon recht kleine - Knopfzelle U so im Gehäuse positioniert werden, daß sie mehr oder weniger die ganze Leiterplatte L, oder daß ihre oben genannte Projektion alle Bauteile B zumindest weitgehend bedeckt, vgl. damit die Figuren 1 und 3 bis 6. Eine besonders kompakte Konstruktion des Handsender läßt sich dann zusätzlich dadurch erreichen, daß die Bauteile B nicht nur auf einer Seite, sondern auf beiden Seiten der Leiterplatte L befestigt sind, vgl. das in der Figur 1 gezeigte Beispiel; - in diesem Fall sind die Bauteile B, welche auf der von der Knopfzelle U abgewandten Seite der Leiterplatte K angebracht sind, beim Batteriewechsel besonders gut gegen Verschmutzung und Beschädigung geschützt.

Das andere Potential der Knopfzelle U kann dann in für sich üblicher Weise über entsprechende andere Kontakte der Leiterplatte L zugeleitet werden. Die Figur 3 zeigt beispielhaft, daß dazu z.B. der dort am Deckel V angebrachte, aus einer brükkenähnlichen Feder F bestehende Kontakt verwendbar ist.

Um auf besonders einfache, kompakte, leicht herstellbare Weise eine entsprechend große Versorgungsspannung und Energiereserve für die Bauteile zu Verfügung stellen zu können, können bei jedem der erwähnten und gezeigten Beispiele im Gehäuse jeweils mehrere, dicht übereinander geschichtete, elektrisch in Reihe geschaltete Knopfzellen U angebracht werden, und zwar so orientiert, daß ihre Achsen zumindest weitgehend fluchten. Vgl. damit die in den Figuren 1 und 2 gezeigten Beispiele.

## Patentansprüche

1. Handsender eines fernsteuerbaren Schließsystemes, bevorzugt für ein Kfz,
- mit einer elektronische Bauteile (B) tragenden Leiterplatte (L) in einem Gehäuse (T/A), das seinerseits aus zumindest einem die Leiterplatte (L) stützenden Tragekörper (T) und einer Abdeckung (A) besteht, und
- mit einer im Gehäuse (T/A) mitangebrachten Batterie (U) zur Stromversorgung der Bauteile (B) über Leiterbahnen der Leiterplatte (L),
**dadurch gekennzeichnet,**
- daß die Batterie (U) durch mindestens eine - zumindest angenähert einen Rotationskörper darstellende - Knopfzelle (U) gebildet wird, die so räumlich orientiert im Gehäuse (T/A) angebracht ist, daß ihre (U) Achse mehr oder weniger senkrecht zur Ebene der Leiterplatte (L) steht und daß die senkrechte Projektion der Knopfzelle (U) auf der Leiterplatte (L) zumindest eines der Bauteile (B) zumindest teilweise bedeckt.

2. Handsender nach Patentanspruch 1,
**dadurch gekennzeichnet,**
- daß die Knopfzelle (U) von dem/den bedeckten Bauteil/-en (B) durch eine massive Trennschicht (H) getrennt ist.

3. Handsender nach Patentanspruch 1,
**dadurch gekennzeichnet,**
- daß die Knopfzelle (U) im Gehäuse (T/A) durch an der Abdeckung (A) Klammern (K) fixiert sind, und
- daß der Abstand der Knopfzelle (U) zu dem/den Bauteil/-en (B) durch die Klammern (K) erzeugt ist.

4. Handsender nach Patentanspruch 1,
**dadurch gekennzeichnet,**
- daß die Knopfzelle (U) im Gehäuse (T/A) durch am Tragekörper (T) und / oder auf der Leiterplatte (L) angebrachte Stützen (S) fixiert sind, und
- daß der Abstand der Knopfzelle (U) zu dem/den Bauteil/-en (B) durch die Stützen (S) erzeugt ist.

5. Handsender nach Patentanspruch 4,
**dadurch gekennzeichnet**, - daß zumindest eine der Stützen (S) einen Kontaktfinger (S) enthält oder darstellt, welcher ein Potential der Knopfzelle (U) zu einer Leiterbahn der Leiterplatte (L) weiterleitet.

6. Handsender nach einem der vorhergehenden Patentansprüche,
**dadurch gekennzeichnet,**
- daß die Leiterplatte (L) eine leitende Fahne (D) trägt, welche ein Potential der Knopfzelle (U) zu einer Leiterbahn der Leiterplatte (L) weiterleitet.

7. Handsender nach Patentanspruch 6,
**dadurch gekennzeichnet**,
- daß die Fahne (D) eine an ihren beiden Enden an der Leiterplatte (L) befestigte Brücke (D) darstellt, welche unter sich zumindest eines der Bauteile (B) zumindest teilweise überspannt, und
- daß die Mitte der Brücke (D) so gegen die Knopfzelle (U) gekrümmt ist oder vorspringt, daß dort ein Potential der Knopfzelle (U) zu einer Leiterbahn der Leiterplatte (L) weitergeleitet wird.

8. Handsender nach Patentanspruch 6 oder 7,
**dadurch gekennzeichnet,**
- daß dann, wenn die Knopfzelle (U) im Gehäuse angebracht ist, die Knopfzelle (U) die Fahne (D) in der Weise zusammendrückt, daß die Knopfzelle (U) auf die Fahne (D), und die Fahne (D) auf mindestens eines der unter der Fahne (D) angebrachten Bauteile (B) drückt.

9. Handsender nach einem der vorhergehenden Patentansprüche,
**dadurch gekennzeichnet**,
- daß die Knopfzelle (U) alle Bauteile (B) zumindest weitgehend bedeckt.

10. Handsender nach einem der vorhergehenden Patentansprüche,
**dadurch gekennzeichnet**,
-daß die Bauteile (B) auf beiden Seiten der Leiterplatte (L) befestigt sind.

11. Handsender nach einem der vorhergehenden Patentansprüche,
**dadurch gekennzeichnet,**
- daß im Gehäuse (T/A) mehrere, dicht so übereinander geschichtete, elektrisch in Reihe geschaltete Knopfzellen (U) angebracht sind, daß ihre Achsen zumindest weitgehend fluchten.

## Claims

1. Portable transmitter of a remote-controllable locking system, preferably for a motor vehicle,
- having a printed circuit board (L), bearing electronic components (B), in a housing (T/A) which itself consists of at least one supporting element (T) which supports the printed circuit board (L), and of a cover (A), and
- having a battery (U) which is also mounted in the housing (T/A) in order to supply power to the components (B) via conductor tracks of the printed circuit board (L), characterized
- in that the battery (U) is formed by at least one round cell (U) which at least approximately constitutes a rotational element and is mounted with spatial orientation in the housing (T/A) in such a way that its (U) axis is more or less perpendicular to the plane of the printed circuit board (L), and in that the perpendicular projection of the round cell (U) on the printed circuit board (L) at least partially covers one of the components (B).

2. Portable transmitter according to Patent Claim 1,
characterized
- in that the round cell (U) is separated from the covered component or components (B) by a solid separating layer (H).

3. Portable transmitter according to Patent Claim 1,
characterized
- in that the round cell (U) is fixed in the housing (T/A) by brackets (K) on the cover (A), and
- in that the distance between the round cell (U) and the component or components (B) is produced by the brackets (K).

4. Portable transmitter according to Patent Claim 1,
characterized
- in that the round cell (U) is fixed in the housing (T/A) by supports (S) which are mounted on the supporting element (T) and/or on the printed circuit board (L), and
- in that the distance between the round cell (U) and the component or components (B) is produced by the supports (S).

5. Portable transmitter according to Patent Claim 4,
characterized
- in that at least one of the supports (S) contains or constitutes a contact finger (S) which conducts a potential of the round cell (U) to a conductor track of the printed circuit board (L).

6. Portable transmitter according to one of the preceding patent claims, characterized
- in that the printed circuit board (L) bears a conductive lug (D) which conducts a potential of the round cell (U) to a conductor track of the printed circuit board (L).

7. Portable transmitter according to Patent Claim 6,
characterized
- in that the lug (D) constitutes a bridge (D) which is attached at its two ends to the printed circuit board (L) which at least partially spans underneath it at least one of the components (B), and
- in that the centre of the bridge (D) is bent or projects towards the round cell (U) in such a way that a potential of the round cell (U) is conducted there to a conductor track of the printed circuit board (L).

8. Portable transmitter according to Patent Claim 6 or 7, characterized
- in that when the round cell (U) is mounted in the housing, the round cell (U) compresses the lug (D) in such a way that the round cell (U) presses on the lug (D) and the lug (D) presses on at least one of the components (B) mounted under the lug (D).

9. Portable transmitter according to one of the preceding patent claims, characterized
- in that the round cell (U) at least largely covers all the components (B).

10. Portable transmitter according to one of the preceding patent claims, characterized
- in that the components (B) are mounted on both sides of the printed circuit board (L).

11. Portable transmitter according to one of the preceding patent claims, characterized
- in that a plurality of round cells (U) which are layered tightly one on top of the other and electrically connected in series are mounted in the housing (T/A) in such a way that their axes are at least largely flush.

## Revendications

1. Emetteur portable d'un système de fermeture pouvant être télécommandé, de préférence pour un véhicule automobile, comportant
- une plaquette de circuit imprimé (L) portant des composants électroniques (B) et située dans un boîtier (T/A) qui est constituée pour sa part par d'au moins un support (T) supportant la plaquette de circuit imprimé (L) et d'un capot (A), et
- une pile (U) logée conjointement dans le boîtier (T/A) et servant à alimenter en courant les composants (B) par l'intermédiaire de pistes conductrices de la plaquette de circuit imprimé (L), caractérisé par le fait
- que la pile (U) est formée par une pile bouton (U) - représentant au moins approximativement un corps de révolution - , qui est logée dans le boîtier (T/A) en étant orientée dans l'espace de telle sorte que son axe (U) soit plus ou moins perpendiculaire au plan de la plaquette de circuit imprimé (L), et que la projection orthogonale de la pile bouton (U) recouvre au moins partiellement au moins l'un des composants (B) sur la plaquette de circuit imprimé (L).

2. Emetteur portable suivant la revendication 1, caractérisé en ce
- que la pile bouton (U) est séparée du ou des composants recouverts (B) , par une paroi massive de séparation (H).

3. Emetteur portable selon la revendication 1, caractérisé en ce
- que la pile bouton (U) est fixée dans le boîtier (U/A) au moyen de crampons (K) fixés au capot (A), et
- que la distance entre la pile bouton (U) et le ou les composants (B) est déterminée par les crampons (K).

4. Emetteur portable selon la revendication 1, caractérisé en ce
- que la pile bouton (U) est fixée dans le boîtier (T/A) par l'intermédiaire de picots (S) disposés sur la plaquette de circuit imprimé (L) et
- que la distance entre la pile (U) et le ou les composants (B) est déterminée par les picots (S).

5. Emetteur portable suivant la revendication 4, caractérisé en ce
- qu'au moins l'un des picots (S) contient ou représente un doigt de contact (S), qui transmet un potentiel de la pile bouton (U) à une piste conductrice de la plaquette de circuit imprimé (L).

6. Emetteur portable selon l'une des revendications précédentes, caractérisé en ce
- que la plaquette de circuit imprimé (L) comprend une languette conductrice (D), qui transmet un potentiel de la pile bouton (U) à une piste conductrice de la plaquette de circuit imprimé (L).

7. Emetteur portable suivant la revendication 6, caractérisé en ce
- que la languette (D) forme un étrier (D), qui est fixé par ses deux extrémités à la plaquette de circuit imprimé (L) et qui s'étend au moins partiellement au-dessous d'au moins l'un des composants (B), et
- que le centre de l'étrier (D) est cintré ou fait saillie en direction de la pile bouton (U) de telle sorte que le potentiel de la pile bouton (U) soit retransmis à une piste conductrice de la plaquette de circuit imprimé (L).

8. Emetteur portable selon la revendication 6 ou 7, caractérisé en ce
- que, lorsque la pile bouton (U) est disposée dans le boîtier, elle comprime la languette (D) de telle sorte qu'elle soit en appui sur la languette (D), et que la languette (D) soit en appui sur au moins l'un des composants (B) disposés au-dessous de la languette (D).

9. Emetteur portable suivant l'une des revendications précédentes, caractérisé par le fait
- que la pile bouton (38) recouvre au moins dans une large mesure tous les composants (B).

10. Emetteur portable selon l'une des revendications précédentes, caractérisé en ce
- que les composants (B) sont fixés sur les deux faces de la plaquette de circuit imprimé (L).

11. Emetteur portable selon l'une des revendications précédentes, caractérisé en ce
- que plusieurs piles bouton (U) superposées directement les unes sur les autres et branchées électriquement en série sont logées dans le boîtier (T/A) de telle sorte que leurs axes soient alignés au moins dans une large mesure.
